# EUROPEAN PATENT APPLICATION

(11) **EP 0 847 079 A2**
(43) Date of publication of application: **10.06.1998**
(21) Application number: 97309818.9
(22) Date of filing: 04.12.1997
(51) Int. Cl.: H01L 21/28, H01L 29/51

(54) **Method of manufacturing an MIS electrode**

(30) Priority: 05.12.1996 US 35375 P
(71) Applicant: TEXAS INSTRUMENTS INCORPORATED, Dallas Texas 75265 (US)
(72) Inventor: Kraft, Robert, Plano, TX 75025 (US); Hattangady, Sunil V., McKinney, TX 75070 (US); Grider, Douglas T., McKinney, TX 75070 (US)
(74) Representative: Nettleton, John Victor

(57) **Abstract**

An embodiment of the instant invention is a method of forming a dielectric layer, the method comprising the steps of: providing a semiconductor substrate (substrate 12), the substrate having a surface; forming an oxygen-containing layer (layer 14) on the semiconductor substrate; and subjecting the oxygen-containing layer to a nitrogen containing plasma (plasma 16) so that the nitrogen is either incorporated into the oxygen-containing layer (see regions 18, 19, and 20) or forms a nitride layer at the surface of the substrate (region 22). Using this embodiment of the instant invention, the dielectric layer can be substantially free of hydrogen. Preferably, the oxygen-containing layer is an SiO₂ layer or it is comprised of oxygen and nitrogen (preferably an oxynitride layer). The plasma is, preferably, a high-density plasma. Preferably, a source of nitrogen is introduced to the plasma to form the nitrogen containing plasma. The source of nitrogen is preferably comprised of a material consisting of: N₂, NH₃, N0,N₂O, or a mixture thereof.

## Description

### FIELD OF THE INVENTION

The instant invention relates generally to semiconductor devices, and more particularly to a method of fabricating and processing semiconductor devices having a gate dielectric layer.

### BACKGROUND OF THE INVENTION

Presently, there is a great demand for smaller semiconductor devices to provide an increased density of devices on the semiconductor chip that are faster and consume less power. The scaling of the devices in the lateral dimension requires vertical scaling as well so as to achieve adequate device performance. This vertical scaling requires the thickness of the gate dielectric to be reduced so as to provide the required device performance. However, thinning of the gate dielectric provides a smaller barrier to dopant diffusion from a polysilicon gate structure or metal diffusion from a metal gate structure and through the underlying dielectric and it may result in devices with diminished electrical performance and reliability.

One means of reducing these problems is to use silicon nitride as the gate dielectric layer. Silicon nitride has a higher dielectric constant than typical thermally grown SiO₂ films and it provides greater resistance to impurity diffusion. However, the electrical properties of standard deposited silicon nitride films are far inferior to thermal oxides. Hence, to make the conventional silicon nitride film useful as a gate insulator, an oxide layer must be formed between the nitride layer and the substrate.

Recently, a technique was developed for depositing a silicon nitride film that has electrical properties similar to that of typical silicon oxide films. This new technique is referred to as Jet Vapor Deposition (JVD). See Xie-wen Wang, et al., Highly reliable Silicon Nitride Thin Films Made by Jet Vapor Deposition, JPN. J. APPL. PHYS., Vol. 34, 955-958 (1995). JVD relies on a jet of a light carrier gas, such as helium, to transport deposition vapor from the source to the substrate. While this technique yields a silicon nitride film that can be used as a gate dielectric, it suffers from the following problems: it is a relatively complex process which involves rastering the plasma jet across the wafer so as to deposit the film on the entire wafer (and this is difficult to reliably accomplish); this process can not be easily scaled up for broad-area film formation on large diameter wafers (e.g. 8-12 inch wafers); hydrogen is incorporated into the resultant film; and this process is a low throughput process because of the tremendously slow deposition rates.

Another method of maintaining the benefit of the electrical properties of the oxide film while also getting the barrier properties of a nitride film is accomplished by incorporating nitrogen into a gate oxide layer. Typically, this is accomplished by a reoxidized nitrided oxide process. This process involves using ammonia to include nitrogen within the gate oxide layer. Unfortunately, in order to get the ammonia to penetrate the gate oxide, temperatures in excess of 1000°C are required. In addition, once the high temperature reaction has begun, it is difficult to control the concentration of the nitrogen incorporated into the gate oxide. Excessive nitrogen near the interface between the semiconductor substrate and the gate oxide can adversely affect the threshold voltage and degrade the channel mobility of the device through Coloumbic effects of the fixed charge and interface-trap charge associated with the nitrogen on the carriers within the channel region.

Other experimental work has been done involving nitridation through exposure to a remote plasma. See S.V. Hattangady, et al., Controlled Nitrogen Incorporation at the Gate Oxide Surface, 66 Appl. Phys. Lett. 3495 (June 19, 1995). This process provided for nitrogen incorporation specifically at the gate-conductor interface using a high pressure (100 milliTorr) and low power (30 Watt) process with relatively low ion-density and ion flux. Low ion-density and ion-flux dictates a long duration (around 10-60 minute) so as to obtain desired concentration of incorporated nitrogen. This long exposure to the plasma increases the probability of charge-induced damage to the oxide. Additionally, throughput is greatly reduced using this method.

It is, therefore, an object of the instant invention to provide a film that has the beneficial barrier properties of a nitride film while having the beneficial electrical properties of an oxide film.

### SUMMARY OF THE INVENTION

An embodiment of the instant invention is a method of forming a dielectric layer, the method comprising the steps of: forming an oxygen-containing layer on a surface of a substrate; and subjecting the oxygen-containing layer to a nitrogen containing plasma so that the nitrogen is either incorporated into the oxygen-containing layer or forms a nitride layer at the surface of the substrate. Using this embodiment of the instant invention, the dielectric layer can be substantially free of hydrogen. Preferably, the oxygen-containing layer is an SiO₂ layer or it is comprised of oxygen and nitrogen (preferably an oxynitride layer). The plasma is, preferably, a high-density plasma. Preferably, a source of nitrogen is introduced to the plasma to form the nitrogen containing plasma. The source of nitrogen is preferably comprised of a material consisting of: N₂, NH₃, NO, N₂0, or a mixture thereof.

According to a further embodiment of the invention a method of forming a transistor having a conductive gate structure disposed on a gate dielectric layer is provided. The method comprises the steps of: providing a dielectric layer on a surface of a substrate, the dielectric layer comprised of an oxide; subjecting the dielectric layer to a nitrogen containing plasma so that nitrogen is either incorporated into the gate insulating layer or forms a nitride layer at the surface of the substrate; and wherein the gate dielectric layer is either comprised of the dielectric layer incorporated with the nitrogen or the nitride layer formed at the surface of the substrate. Preferably, the conductive gate structure is comprised of doped polysilicon or a metal. Using this method, the gate dielectric layer can be substantially free of hydrogen. Preferably, the dielectric layer is an SiO₂ layer or is an oxynitride layer.

According to a yet further embodiment of the invention a method of forming a capacitor having a capacitor dielectric is provided. The method comprises the steps of: forming a first electrode over a semiconductor substrate; providing a dielectric layer on the first electrode, the dielectric layer comprised of an oxide; subjecting the dielectric layer to a nitrogen containing plasma so that nitrogen is either incorporated into the dielectric layer or forms a nitride layer at the surface of the first electrode; forming a second electrode on the dielectric layer after the dielectric layer is subjected to the plasma; and wherein the capacitor dielectric is either comprised of the dielectric layer incorporated with the nitrogen or the nitride layer formed at the surface of the first electrode.

### BRIEF DESCRIPTION OF THE DRAWINGS

The present invention will now be further described way way of example, with reference to the accompanying drawings in which:
Figures 1, 2 and 3a are cross-sectional views of a semiconductor device during fabrication according to an illustrative first embodiment of the present invention;
Figures 1, 2 and 3b are cross-sectional views of a semiconductor device during fabrication according to a further illustrative embodiment of the present invention;
FIGUREs 4a and 4b are flow charts that illustrate the methods of the embodiments illustrated in Figures 1,2,3a and 3b; and
FIGUREs 5-8 are graphs illustrating the amount of oxygen and nitrogen in gate dielectric layers formed using the methods illustrated in Figures 1,2, 3a and 3b.

### DETAILED DESCRIPTION OF THE DRAWINGS

The following description refers to two illustrative embodiments of the instant invention. While the description of both embodiments involves the novel formation of a gate dielectric, these methods are not limited to the formation of a gate dielectric layer. The instant embodiments can be utilized to form other layers required in the formation of semiconductor devices. For example, the principles disclosed therein can be utilized to form the dielectric material in a capacitor structure or can be used to isolate conductive structures. While the following description describes the formation of a gate dielectric layer, one of ordinary skill in the art should be able to use the teachings of the following description and form other layers in a semiconductor device. Like reference numerals are utilized in the figures to illustrate like features or similar process steps.

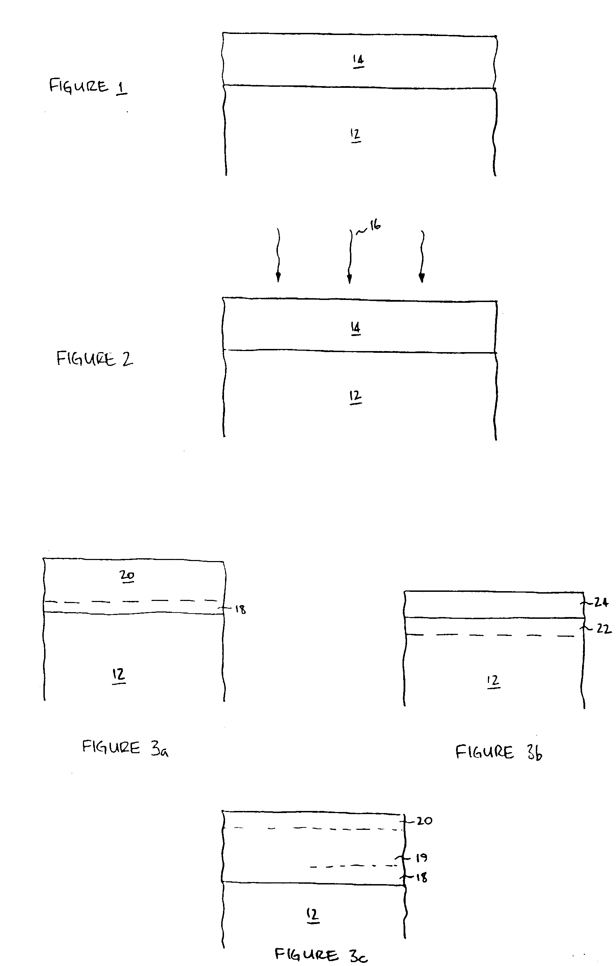

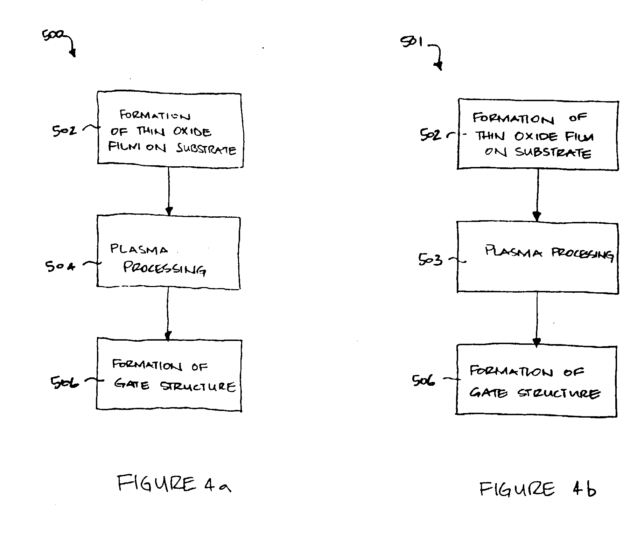

Referring to the embodiment illustrated in FIGUREs 1, 2, and 3a and FIGURE 4a, insulating layer 14 is formed on semiconductor structure 12 (which is preferably a silicon substrate or an epitaxial silicon layer formed on a silicon substrate). Preferably, insulating layer 14 is a 10 to 150 Angstram thick oxide-containing layer [preferably either an oxide layer, an oxynitride layer, or other insulating layer] (more preferably a 10 to 80 Angstram thick oxide layer -- even more preferably a 10 to 45 Angstram thick oxide layer) which is either thermally grown, deposited, or a combination thereof. This step corresponds to block 502 of FIGURE 4a. Referring to FIGURE 2 and step 504 of FIGURE 4a, insulating layer 14 is subjected to a plasma which is incorporated with a nitrogen-containing substance. Preferably, the nitrogen-containing substance is either N₂, NH₃, NO, N₂O, or a mixture thereof, and the plasma is preferably a high density plasma. The wafer can be unbiased in which case the ionized substances are accelerated by the plasma potential (which is typically on the order of 20 Volts) and then implanted into the insulating surface. A bias voltage can be applied to the wafer to further accelerate the ions from the plasma and implant them deeper into the insulating layer. Either a DC or an RF bias voltage can be used to bias the wafer. Most preferably, step 504 is performed with the following processing conditions: the starting oxide thickness is between 10 to 150 Angstrams thick; the plasma density is between 1x10¹⁰ to 1x10¹² cm⁻³; the nitrogen is on the order of 1 to 100 sccm; the process pressure is preferably on the order of 1 to 50 mTorr; the temperature is preferably around 70 to 900K; the substrate (wafer) bias is on the order of 0 to 50 Volts; and the duration of exposure is between 1 to 60 seconds.

FIGURE 3a illustrates the results of step 504. Depending on the bias of the wafer and the density of the plasma, nitrogen is incorporated into insulating layer 14. This results in a Si/N/O portion 20 of layer 14 and a Si/O/N portion 18 of layer 14. Preferably, the amount of nitrogen exceeds the amount of oxygen in portion 20. In fact it may be preferable that there is much more nitrogen than oxygen (may be even very little or no oxygen) in portion 20. Portion 18 may be substantially the same as portion 20 or these two portions may be comprised of different amounts of silicon, nitrogen, and oxygen. In fact, portion 18 may remain a relatively pure SiO₂ film, it may be comprised mostly of silicon and nitrogen, or it may comprise some proportion of silicon, nitrogen and oxygen which lies in between these two extremes. The amount of nitrogen added depends on the process conditions, and, therefore, these process conditions may be manipulated so as to optimize the process for any transistor design.

Furthermore, the transition between portions 18 and 20 may not be sharp and may be graded with respect to the nitrogen concentration. Alternatively, the transition between portions 18 and 20 may be characterized by a region (region 19 of FIGURE 3c) with little or no nitrogen, that is bound on either side by nitrogen-containing portions (portions 18 and 20). More specifically, the embodiment of FIGURE 3c can be comprised of oxynitride portion 18, mostly oxide-containing portion 19, and either nitride portion or oxynitride portion 20.

Referring to the embodiment of FIGUREs 1, 2, and 3b and of FIGURE 4b, gate insulator 14 is formed on semiconductor structure 12 (preferably either a silicon substrate or an epitaxial silicon layer formed on a silicon substrate) using standard processing. Preferably, gate insulator 14 is comprised of 10 to 200 Angstrams (more preferably 10 to 80 Angstrams -- even more preferably 10 to 45 Angstrams ) thick thermally grown SiO₂ film, deposited SiO₂ film, or a film formed as a combination thereof. Next, referring to FIGURE 2 and step 503 of FIGURE 4b, the wafer is subjected to a nitrogen-containing plasma. Preferably, the plasma is a high density plasma (preferably formed from a helicon source, a helical-resonator source, electron-cyclotron resonance source, or an inductively coupled source -- or it can be a low density plasma), and the nitrogen-containing source is either N₂, NH₃, NO, N₂O, or a mixture thereof. With the appropriate biasing of the wafer (preferably around 0-500 Volts) the ionized species contained in the plasma will pass through dielectric layer 14 and react at the surface of semiconductor structure 12. Preferably, this will result in the formation of a silicon nitride layer 22, which is formed as part of semiconductor structure 12. Dielectric layer 14 (which is referred to as layer 24 in FIGURE 3b) may trap some of the nitrogen or the nitrogen may simply pass through it. In addition, as plasma 16 is introduced gate insulator may be completely sputtered away, partially sputtered away to form layer 24 (preferably comprised of silicon, oxygen, and some amount of nitrogen), or it may not be removed. Preferably, the process conditions utilized in step 503 of FIGURE 4b is as follows: the oxide thickness is around 10 to 80 Angstrams thick (preferably around 20 Angstrams thick); the plasma density is around 1x10¹⁰ to 1x10¹² cm⁻³; the nitrogen flow is around 1 to 100 sccm; the process pressure is around 4 mTorr; the temperature is around 300K; the substrate (wafer) bias is around 0 to 500 Volts; and the duration of the exposure to the plasma is around 1-60 seconds.

In both step 504 of FIGURE 4a and step 503 of FIGURE 4b, substrate bias, length (in time) of exposure to the plasma, plasma power, and use of a post nitridation anneal can be altered/used so as to either drive the nitrogen further into or not drive as far into the insulating layer or the underlying semiconductor structure and repair any dielectric and/or substrate damage. In addition, a low density plasma or a high density plasma may be used depending on the amount of drive-in that is required for the nitrogen.

The instant embodiments may be utilized to form any of the following: a homogeneous silicon oxynitride layer, a homogeneous silicon nitride layer, an interfacial silicon oxynitride or silicon nitride layer at the uppermost surface of the gate insulating layer, an interfacial silicon oxynitride or silicon nitride layer at the uppermost surface and/or the bottommost surface of the gate insulating layer. Preferably, the gate insulator formed using this method will have a composition of 0.1 to 57 atomic percent of nitrogen.

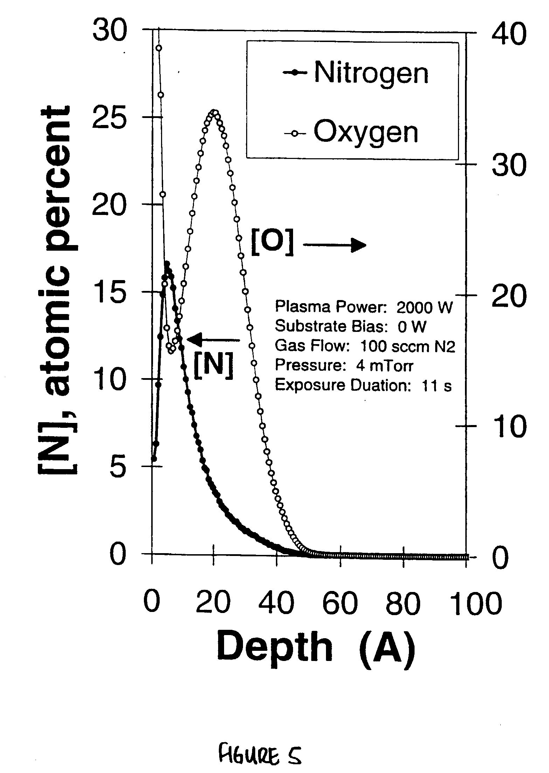

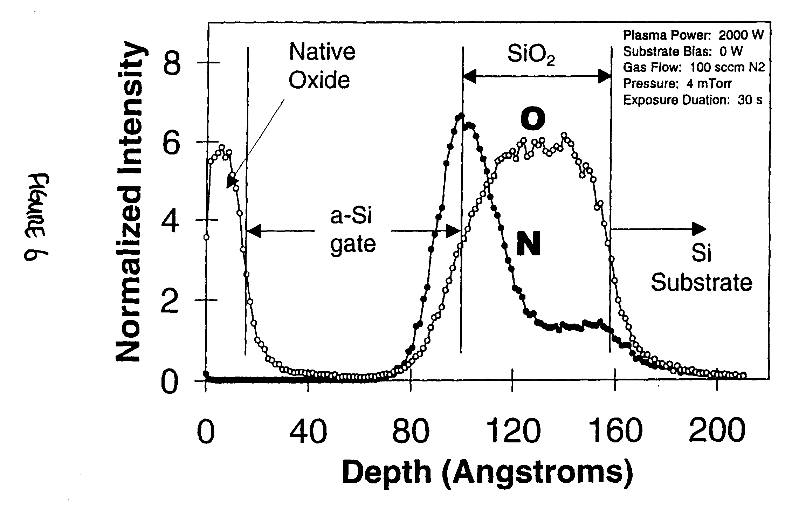

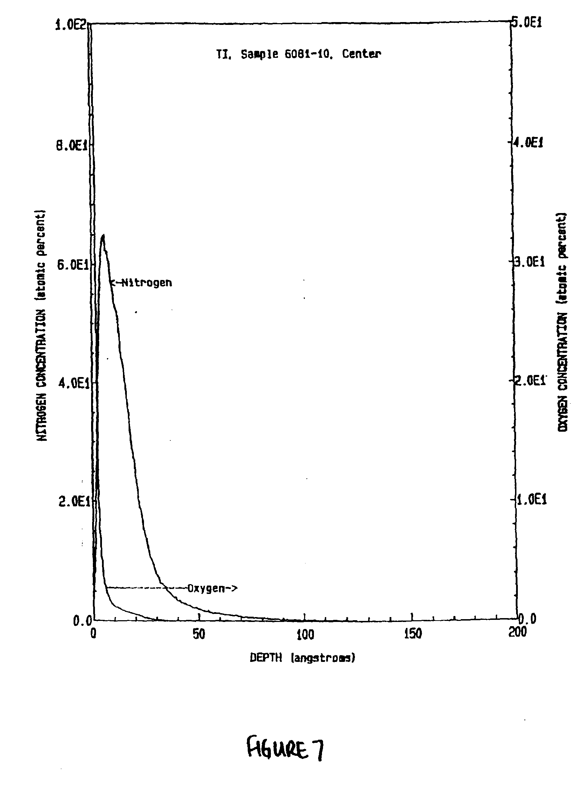

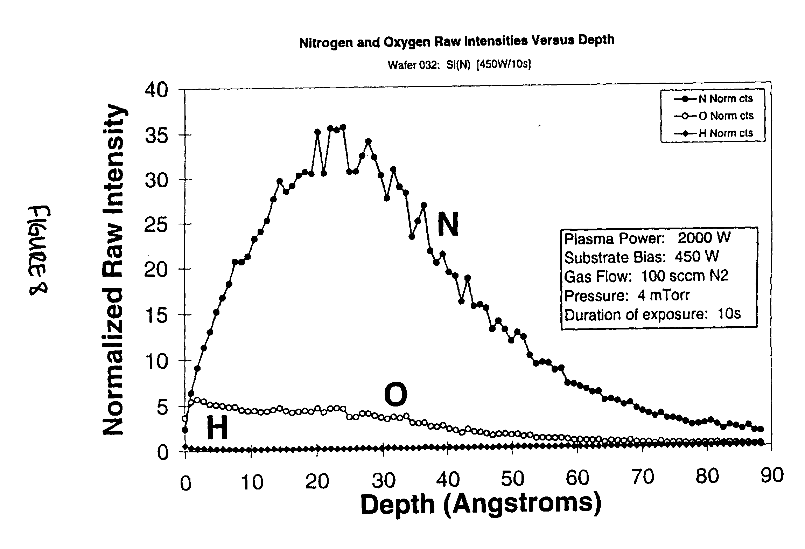

FIGUREs 5-8 are graphs illustrating the level of oxygen and nitrogen in gate dielectric films formed using the methods of the instant invention. FIGURE 5 illustrates data taken from a SIMS analysis of a 60 oxide film nitrided under the following conditions: the plasma power was 2000W (for a high-density helicon-based plasma); the substrate bias was 0 Watts; the gas flow was 100 sccm of N₂; the ambient pressure was 4 mTorr; and the duration of the exposure to the plasma was 11 seconds. FIGURE 5 shows nitrogen incorporation at the top surface/interface. Figure 6 illustrates data taken from a time-of-flight SIMS analysis of a 60 Angstram oxide film nitrided under the following conditions: the plasma power was 2000W (for a high-density helicon-based plasma); the substrate bias was 0 Watts; the gas flow was 100 sccm of N₂; the ambient pressure was 4 mTorr; and the duration of the exposure to the plasma was 30 seconds. FIGURE 6 shows nitrogen incorporation at the top and bottom interfaces. FIGURE 7 illustrates data taken from a SIMS analysis of a 35 Angstram oxide film nitrided under the following conditions: the plasma power was 2000W (for a high-density helicon-based plasma); the substrate bias was 100 Watts (13.56 MHz); the gas flow was 100 sccm of N₂; the ambient pressure was 4 mTorr; and the duration of the exposure to the plasma was 60 seconds. FIGURE 7 Angstram shows a substantially complete formation of silicon nitride with a small amount of oxygen remaining behind in the film. FIGURE 8 illustrates data taken from a time of flight SIMS analysis of a 7 Angstram oxide film nitrided under the following conditions: the plasma power was 2000W (for a high-density helicon-based plasma); the substrate bias was 450 Watts (13.56 MHz); the gas flow was 100 sccm of N₂; the ambient pressure was 4 mTorr; and the duration of the exposure to the plasma was 10 seconds.

Although specific embodiments are herein described, they are not to be construed as limiting the scope of the invention. Many embodiments of the present invention will become apparent to those skilled in the art in light of methodology of the specification.

## Claims

1. A method of forming a dielectric layer comprising the steps of:
forming an oxygen-containing layer on a surface of a substrate; and
subjecting said oxygen-containing layer to a nitrogen containing plasma so that said nitrogen is either incorporated into said oxygen-containing layer or forms a nitride layer substantially at said surface of said substrate.

2. The method of Claim 1, further comprising:
performing said forming and subjecting steps such that said dielectric layer is substantially free of hydrogen.

3. The method of Claim 1 or Claim 2, wherein said step of forming said oxygen-containing layer comprises forming a SiO₂ layer.

4. The method of Claim 1 or Claim 2, wherein said step of forming said oxygen-containing layer comprises forming a layer comprised of oxygen and nitrogen.

5. The method of Claim 1 or Claim 2, wherein said step of forming said oxygen-containing layer comprises forming an oxynitride layer.

6. The method of any preceding claim, wherein said step of subjecting said oxygen-containing layer to a plasma comprises subjecting said oxygen-containing layer to a high-density plasma.

7. The method of any preceding claim, further comprising introducing a source of nitrogen to said plasma to form said nitrogen containing plasma.

8. The method of Claim 7, wherein said step of introducing said source of nitrogen comprises introducing a source of nitrogen comprised of material consisting of: N₂, NH₃, NO, N₂O, or a combination thereof.

9. A method of forming a transistor having a conductive gate structure disposed on a gate dielectric layer, said method comprising the steps of:
providing a dielectric layer on a substrate, said dielectric layer comprised of an oxide;
subjecting said dielectric layer to a nitrogen containing plasma so that nitrogen is either incorporated into said gate insulating layer or forms a nitride layer substantially at said surface of said substrate;
and wherein said gate dielectric layer is either comprised of said dielectric layer incorporated with said nitrogen or said nitride layer formed substantially at said surface of said substrate.

10. The method of Claim 9, further comprising:
forming said conductive gate structure from doped polysilicon.

11. The method of Claim 9, further comprising:
forming said conductive gate structure from a metal.

12. The method of any of Claims 9 to 11, further comprising performing said forming and subjecting steps such that said gate dielectric layer is substantially free of hydrogen.

13. The method of any of Claims 9 to 12, wherein said step of forming said dielectric layer is a SiO₂ layer.

14. The method of any of Claims 9 to 12, wherein said step of forming said dielectric layer comprises forming an oxynitride layer.

15. A method of forming a capacitor having a capacitor dielectric comprising the steps of:
forming a first electrode over a substrate;
providing a dielectric layer on said first electrode, said dielectric layer comprised of an oxide;
subjecting said dielectric layer to a nitrogen containing plasma so that nitrogen is either incorporated into said dielectric layer or forms a nitride layer substantially at a surface of said first electrode;
forming a second electrode on said dielectric layer after said dielectric layer is subjected to said plasma;
and wherein said capacitor dielectric is either comprised of said dielectric layer incorporated with said nitrogen or said nitride layer formed substantially at said surface of said first electrode.
